(19)

**Europäisches Patentamt**
**European Patent Office**
**Office européen des brevets**

(11)  **EP 4 249 874 B1**

(12) **EUROPEAN PATENT SPECIFICATION**

(45) Date of publication and mention
of the grant of the patent:
**22.05.2024  Bulletin 2024/21**

(21) Application number: **22305348.9**

(22) Date of filing: **23.03.2022**

(51) International Patent Classification (IPC):
***G01K 7/01*** *(2006.01)*          ***G01K 15/00*** *(2006.01)*

(52) Cooperative Patent Classification (CPC):
**G01K 15/005; G01K 7/01**

(54) **JUNCTION TEMPERATURE INHOMOGENEITY ESTIMATION METHOD FOR POWER SEMICONDUCTORS**

VERFAHREN ZUR ABSCHÄTZUNG DER INHOMOGENITÄT DER SPERRSCHICHTTEMPERATUR BEI LEISTUNGSHALBLEITERN

PROCÉDÉ D'ESTIMATION D'INHOMOGÉNÉITÉ DE TEMPÉRATURE DE JONCTION POUR SEMI-CONDUCTEURS DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.09.2023  Bulletin 2023/39**

(73) Proprietors:
• **Mitsubishi Electric R&D Centre Europe B.V.**
**1119 NS  Schiphol Rijk Amsterdam (NL)**
Designated Contracting States:
**FR**
• **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI GB GR HR HU IE IS IT LI LT LU LV MC MK MT NL NO PL PT RO RS SE SI SK SM TR**

(72) Inventors:
• **BRANDELERO, Julio**
**35708 RENNES CEDEX 7 (FR)**
• **BAUDAIS, Briac**
**35708 RENNES CEDEX 7 (FR)**

(74) Representative: **Plasseraud IP**
**66, rue de la Chaussée d'Antin**
**75440 Paris Cedex 09 (FR)**

(56) References cited:
• **BRANDELERO JULIO ET AL: "Selective Gate Driving in Intelligent Power Modules", IEEE TRANSACTIONS ON POWER ELECTRONICS, INSTITUTE OF ELECTRICAL AND ELECTRONICS ENGINEERS, USA, vol. 36, no. 1, 12 June 2020 (2020-06-12), pages 898-910, XP011808042, ISSN: 0885-8993, DOI: 10.1109/TPEL.2020.3002188 [retrieved on 2020-09-07]**
• **Julio Brandelero ET AL: "On-line Virtual Junction Temperature Measurement via DC Gate Current Injection", CIPS 2018 - 10th International Conference on Integrated Power Electronics Systems, 20-22 March 2018, Stuttgart, Germany, 5 July 2018 (2018-07-05), XP055604490, Berlin - Offenbach ISBN: 978-3-8007-4540-1 Retrieved from the Internet: URL:https://ieeexplore.ieee.org/ielx7/8402 817/8402818/08403170.pdf?tp=&arnumber=8403 170&isnumber=8402818&ref=aHR0cHM6Ly9pZ WVle HBsb3JlLmllZWUub3JnL2RvY3VtZW50Lzg0MD MxNzA = [retrieved on 2019-07-10]**
• **BAKER NICK ET AL: "The Temperature Dependence of the Flatband Voltage in High-Power IGBTs", IEEE TRANSACTIONS ON INDUSTRIAL ELECTRONICS, IEEE SERVICE CENTER, PISCATAWAY, NJ, USA, vol. 66, no. 7, 1 July 2019 (2019-07-01), pages 5581-5584, XP011712534, ISSN: 0278-0046, DOI: 10.1109/TIE.2018.2854568 [retrieved on 2019-03-01]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 249 874 B1

- SUNDARAMOORTHY V. K. ET AL: "Online junction temperature estimation for IGBT modules with paralleled semiconductor chips", 7TH IET INTERNATIONAL CONFERENCE ON POWER ELECTRONICS, MACHINES AND DRIVES (PEMD 2014), [Online] 1 January 2014 (2014-01-01), pages 1.9.01-1.9.01, XP055960163, DOI: 10.1049/cp.2014.0406 ISBN: 978-1-84919-815-8 Retrieved from the Internet: URL:https://ieeexplore.ieee.org/stampPDF/g etPDF.jsp?tp=&arnumber=6836900&ref=aHR0c HM 6Ly9pZWVleHBsb3JlLmllZWUub3JnL2Fic3RyYY WN0L2RvY3VtZW50LzY4MzY5MDA=> [retrieved on 2022-09-19]

## Description

## Technical Field

This disclosure pertains to the field of power semiconductor monitoring. The following article deals with such power semiconductors: BRANDELERO Julio et al.: "Selective Gate Driving in Intelligent Power Modules", IEEE TRANSACTIONS ON POWER ELECTRONICS, INSTITUTE OF ELECTRICAL AND ELECTRONICS ENGINEERS, USA, vol. 36, no. 1, 12June 2020 (2020-06-12), pages 898-910, ISSN: 0885-8993, DOI: 10.1109/TPEL.2020.3002188.

## Background Art

It is known to monitor temperature in power semiconductor Metal-Oxide-Semiconductor type (MOS) or paralleled connected power semiconductor MOS types, especially in power semiconductors devices/modules, like multichip power modules, for protection, condition and health monitoring. Generally, the free surface of a die is very small. To fix a sensor on it is difficult, and even impossible in some cases. Theoretically, using individual gate access of the power dies to measure the individual gate resistances, which are thermal sensitive parameter, would be obvious. But the number of external connections is high, and the acquisition system is complex. To do it in laboratory conditions is very difficult. In real, industrial and operational situations, to use individual PN junction sensors is not realistic.

In addition, sensors have to be integrated inside the power module packaging which means that the presence of sensors have to be initially planned during the conception of the module and to retrofit to the existing power modules is impossible.

Many Temperature Sensitive Electrical Parameters (TSEP) based methods and in-chip sensors for on-line junction temperature estimation on power semiconductor are known. The followings are examples of measures and operations used to deduce a TSEP :

-    the gate voltage plateau sensing during turn-on
-    the turn-off delay time ($t_{dOff}$),
-    the turn-on delay time ($t_{dOn}$),
-    the time duration of Miller plateau,
-    the quasi threshold voltage via the auxiliary emitter (source) and the power emitter (source),
-    the peak of the transient gate current during turn-on,
-    applying a sinusoidal voltage on the gate-emitter and instantly measuring the voltage drop across the external gate resistor,
-    injecting a DC current into the gate path of the power die and measuring the voltage across the gate emitter.

For each one of these known methods, the necessary calibration of the TSEP is only possible in a homogeneous temperature. Although, temperature inhomogeneities during the normal operation will lead to erroneous junction temperature estimations because only a single TSEP is available for the paralleled dies. The accuracy of the TSEP depends on the average, maximum or minimum temperatures. As explained in C. Chen, V. Pickert, B. Ji, C. Ji, A. Knoll and C. Ng, "Comparison of TSEP Performances Operating at Homogeneous and Inhomogeneous Temperature Distribution in Multichip IGBTPower Modules" IEEE Journal of Emerging and Selected Topics in Power Electronics, the Collector-Emitter Voltage ($V_{ce}$) is one of the TSEP with the best accuracy for the average temperature while other TSEP as the $dV_{CE}/dt$ fails completely in estimating the junction temperature. The main reason is that the hottest die has the highest Miller capacitance and consequently would have the slowest rising of $V_{CE}$. Furthermore, the Miller plateau difference estimates the average temperature. In M. Hoeer, F. Filsecker, M. Wagner and S. Bernet, "Application issues of an online temperature estimation method in a high-power 4.5 kV IGBT module based on the gate-emitter threshold voltage", 2016, 18th European Conference on Power Electronics and Applica, the quasi-threshold method has been investigated for dies in parallel. The method shows that the lowest threshold Voltage (Vtn) is measured, which may correspond to the maximum junction temperature ($T_j$) if all the dies have the same $V_{th}$ which it's not the case (an error up to 25K for 50K increase has been measured). Moreover, as the performance of the dies are related to the temperature, a temperature imbalance will change the TSEP sensitivity and linearity.

Losses and thermal models can be used to compensate the estimated virtual junction temperature to the maximum or to temperature difference between the dies. Nonetheless, these methods require complex calibration system of the loss and thermal models and will lose accuracy during the lifetime of the power modules in case of solder layer degradation, or generally if differences appear between operational conditions during the lifetime of the module and the initial model.

Summary

This disclosure improves the situation.

It is proposed a measurement method for estimating temperatures of a power semi-conductor module comprising a single Metal-Oxide-Semiconductor, a single Metal-insulator-Semiconductor or a set of Metal-Oxide-Semiconductors or Metal-insulator-Semiconductors paralleled connected. The method comprises:

- at least one first series of operations, during which the module is in a reference state, including

    a. injecting a positive current $I_{g,ref}$ from the emitter/source to the gate of said module, an initial voltage $V_{0,ref}$ of the module, i.e. a gate-emitter/source voltage (Vge), being superior to a flatband voltage $V_{fb}$,
    b. measuring the voltage $V_{ig,ref}(t)$ across the current source,
    c. stop the current injection $I_{g,ref}$ when the voltage of the module ($V_{ge}$) becomes inferior to the flatband voltage $V_{fb}$,

- at least one second series of operations, during which the module is in a operational state, including d. injecting a positive current $I_{g,op}$ from the emitter/source to the gate of said module, an initial voltage $V_{0,op}$ of the module, i.e. a gate-emitter/source voltage (Vge), being superior to a flatband voltage $V_{fb}$,

    e. measuring the voltage $V_{ig,op}(t)$ across the current source,
    f. stop the current injection $I_{g,op}$ when the voltage of the module ($V_{ge}$) becomes inferior to the flatband voltage $V_{fb}$, then,

- at least one third series of operations including

    g. comparing the voltages $V_{ig,ref}(t)$ and $V_{ig,op}(t)$ measured respectively during one said first series and one said second series,
    h. deducing, from the comparison, a temperature dispersion $T_{j,dev}$ across the module.

In another aspect, it is proposed a system for estimating temperatures of a power semi-conductor module comprising a single Metal-Oxide-Semiconductor, a single Metal-insulator-Semiconductor or a set of Metal-Oxide-Semiconductors or Metal-insulator-Semiconductors paralleled connected, and being arranged to implement the method described here.

In another aspect, it is proposed a computer software comprising instructions to cause the system to implement the method as defined here when the software is executed by a processor. In another aspect, it is proposed a computer-readable non-transient recording medium on which the computer software is registered, wherein the computer software comprises instructions to cause the system to implement the method as defined here when the software is executed by a processor.

The following features, can be optionally implemented, separately or in combination one with the others:

Each of said at least one first series and said at least one second series further comprises: i. acquiring an absolute average temperature $T_{av,ref}$ and $T_{av,op}$ of the module, wherein said second series is repeatedly executed until that the difference between the absolute average temperatures $T_{av,ref}$ and $T_{av,op}$ acquired during said at least one first series and during said second series is equal or inferior to a predetermined value $\Delta T_{lim}$.

A plurality of said first series is executed at different absolute average temperatures $T_{av,ref,n}$, wherein said first series are executed during states different from an operational state of the module..

A plurality of said first series is executed at different absolute average temperatures $T_{av,ref,n}$, wherein each said first series is executed during a reference and operational state of the module, and before reaching a predefined operating age limit in operational operation of said module.

Said third series further comprises, before comparison:

g'. adjusting, in time and in offset, the measured voltage $V_{ig,op}(t)$ during said at least one second series with respect to the waveform of the measured voltage $V_{ig,ref}(t)$ during said at least one first series.

Each said at least one first series is executed when the power transferred by the module is inferior to a predefined limit strictly inferior to the nominal maximum load of the module.

**Brief Description of Drawings**

Other features, details and advantages will be shown in the following detailed description and on the figures, on which:

**Fig. 1**

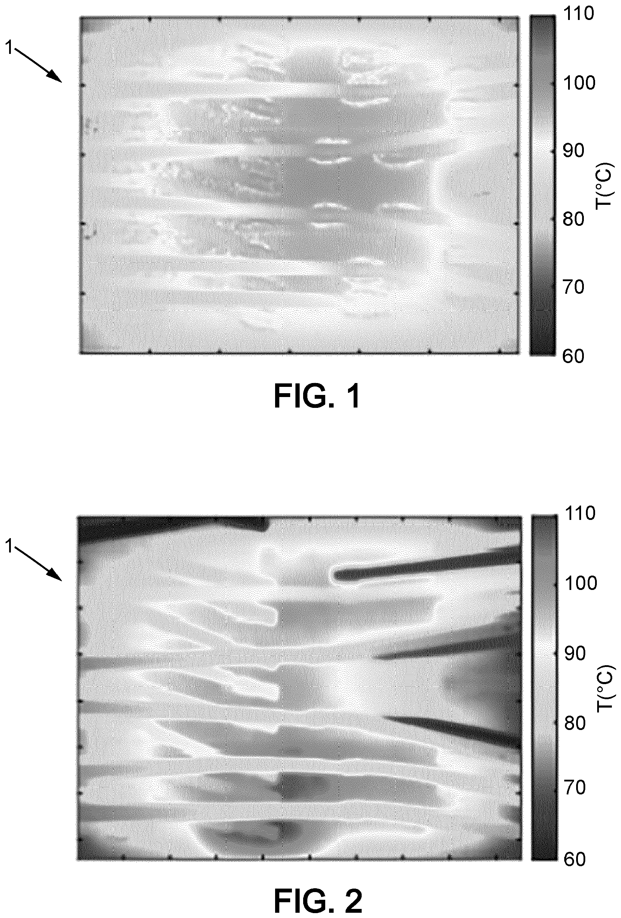

[Fig. 1] is a thermal view of a semiconductor device at the beginning of its life use (a new one).

**Fig. 2**

[Fig. 2] is a thermal view of a semiconductor device at during its life use (a deteriorated one).

**Fig. 3**

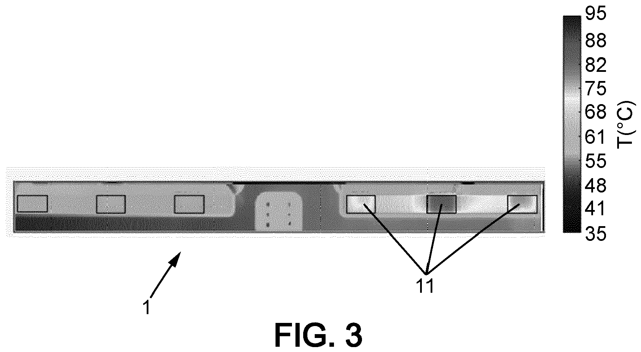

[Fig. 3] is a thermal view of a semiconductor module including six parallel connected semiconductor devices.

**Fig. 4**

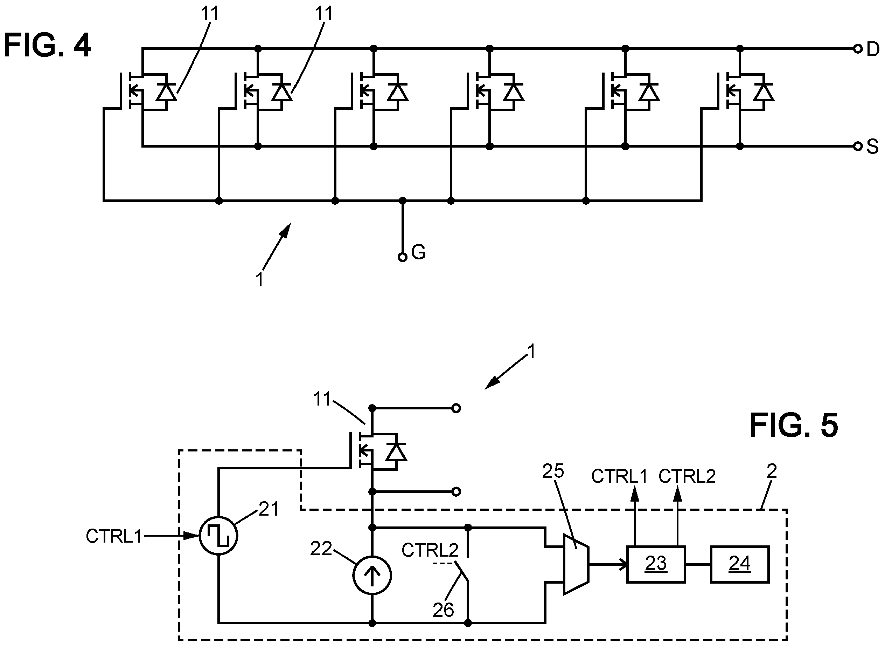

[Fig. 4] is the equivalent circuit of the module shown on [Fig. 3].

**Fig. 5**

[Fig. 5] is circuitry according to an embodiment.

**Fig. 6**

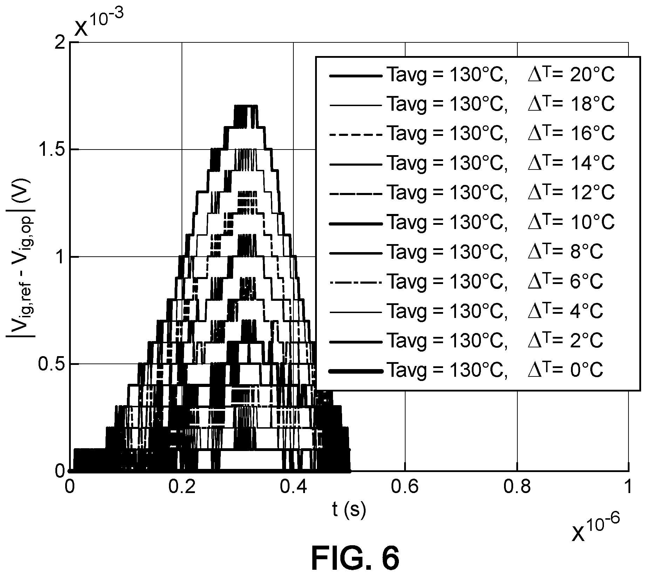

[Fig. 6] is a graphic view of some data obtained during an embodiment.

**Fig. 7**

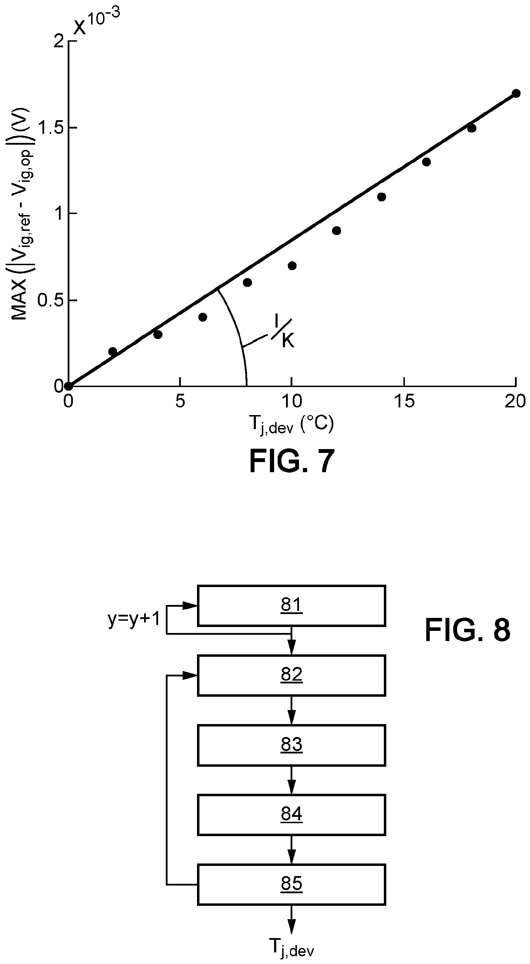

[Fig. 7] is a graphic view of some data obtained during an embodiment.

**Fig. 8**

[Fig. 8] is a flowchart executed during an embodiment.

**Fig. 9**

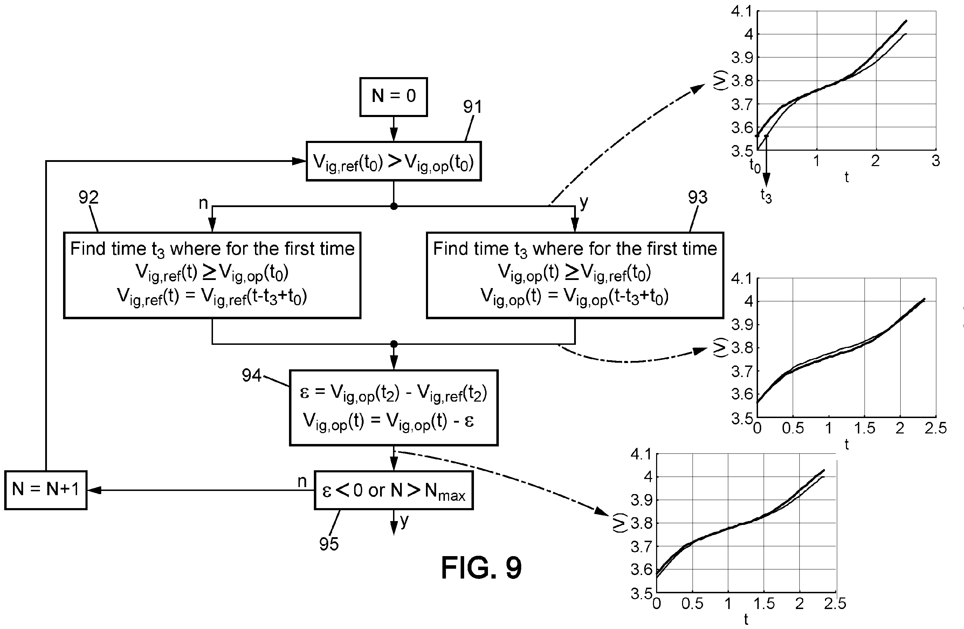

[Fig. 9] is a flowchart of an algorithm executed during an embodiment.

**Fig. 10**

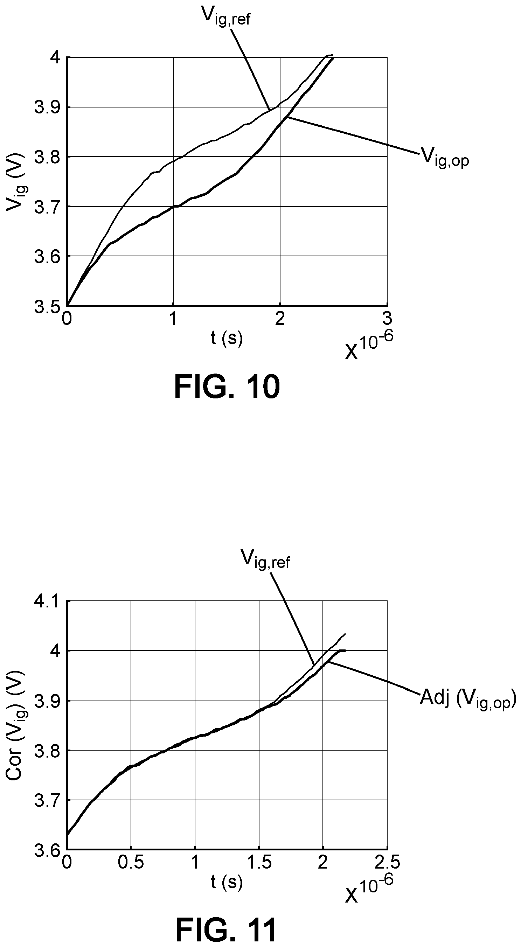

[Fig. 10] is a graphic view of voltages in function of time.

**Fig. 11**

[Fig. 11] is the same graphic view as [Fig. 10] after an adjustment of values/curves.

**Fig. 12**

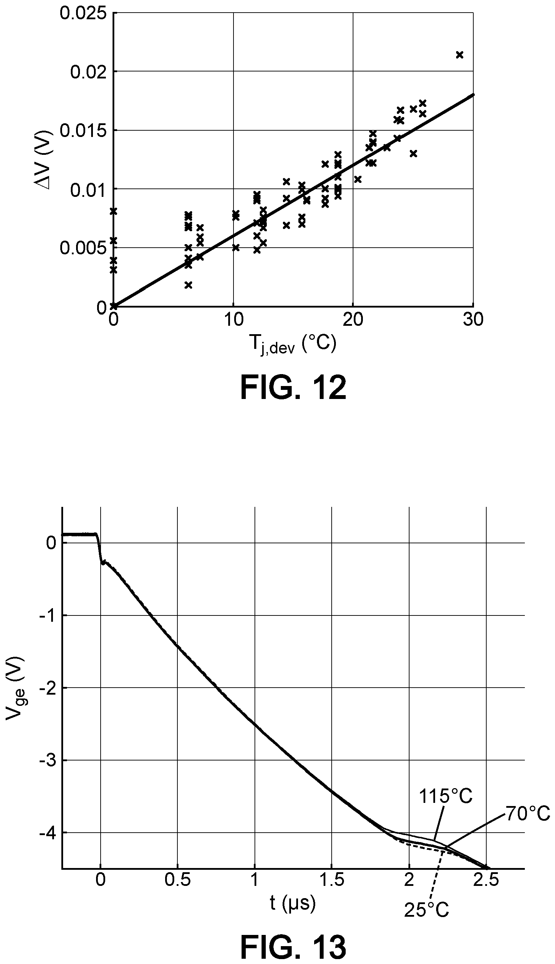

[Fig. 12] is a graphic view of voltages deviation in function of temperatures deviations.

**Fig. 13**

[Fig. 13] is a graphic view of a gate-emitter voltage in function of time.

## Description of Embodiments

It is now referred to figures 1 to 4. [Fig. 1] and [Fig. 2] are thermal pictures of two power semi-conductor modules 1 having the same architecture but taken at two different steps of their operating life. Module 1 of [Fig. 1] is new and in operating conditions from a short time while module 1 shown on [Fig. 2] is deteriorated by operating conditions from a long time. Such pictures clearly show that important heterogeneity of temperatures in a single device (here a die) can appear during lifetime of a module 1. [Fig. 3] and [Fig. 4] show another power semi-conductor module 1 comprising six parallel connected semi-conductor elements 11 (dies). Such pictures clearly show that important heterogeneity of temperatures can appear between devices (here dies) of the same module 1 during lifetime of the module 1.

To monitor such temperatures in laboratory conditions, some of measurements method can be used. Here, a measurement method for estimating temperatures of a power semi-conductor module 1 is proposed that can be used in operational conditions, typically not on a test bench but when the module is integrated and interconnected in its operational and application environment.

In the following, power semi-conductor modules are assembly comprising a single Metal-Oxide-Semiconductor (MOS) transistor, a single Metal-insulator-Semiconductor (MIS) or a set of MOS/MIS transistor paralleled connected. Herein, the transistor are MOSFETs ("*Metal Oxide Semiconductor Field Effect Transistor*") but IGBT ("*Insulated Gate Bipolar Transistor*") can also be used. When a plurality of MOS/MIS are paralleled connected, there is a common gate G, a common source S and a common drain D. For this reason, it is referred to a single gate, a single source and a single drain in the following without distinction of embodiments with a single one or a plurality of MOS transistor elements. The word "power" is used in its general meaning of the technical field of energy conversion (power electronics).

The method comprises:

- at least one first series I of operations, during which the module 1 is in a reference state,
- at least one second series II of operations, during which the module 1 is in an operational state, and
- at least one third series III of operations.

The reference state corresponds to a state wherein the MOS is/are in a known state: the temperature heterogeneity in the module 1 is known to be inferior to predetermined maximum $\Delta T_{ref}$, preferably as low as possible. For example, all the dies are heated to the same temperature and no power is dissipated on the dies. Such a reference state enables to obtain reference values for the module 1.

In the following examples, such a reference state is controlled. But, in various embodiments, the reference state can correspond to a specific period of operation of the module 1 during which the MOS element(s) 11 is/are in a known stable state, for example an off state.

In the following examples, the module 1 comprises (or is connected to) a control circuitry 2, including:

- a voltage source 21 ($V_{drive}$) arranged to pre-set the voltages of the MOS element(s) 11 of the module 1 at a value $V_{0,ref}$ superior to its flatband voltage $V_{fb}$; such a voltage source 21 can be not specifically dedicated to the method described here. In other words, the voltage source 21 can be a usual component of the module which is also active during classical operations of the module;
- a current source 22 ($I_g$), for example from 1mA to 100mA;
- a control unit 23 arranged to start and stop the current source 22, here via a control line CTRL2;
- voltage measurements means
- a calculation unit 24 arranged to implement the third series III of operations.

[Fig. 5] shows an example of implementation a control circuitry 2 and a module 1. For simplification, a single MOS element 11 is represented on [Fig. 5]. But the single MOS element 11 could be replaced by a plurality of MOS elements 11 paralleled connected. In the example, the control circuitry 2 further comprises a Analog-to-Digital Converter (ADC) 25 associated to the control unit 23 and a switch 26 arranged to control the feeding of the MOS element(s) 11 by the current source 22 and controlled by the control unit 23, here via a control line CTRL2.

An electrical isolation between the switch 26 and the ADC 25, and/or between the ADC 25 and control unit 23, and/or between signal lines CTRL1 and CTRL2 can also be provided.

The first series I of operations is, for example, executed by the control circuitry 2, and especially driven by its control unit 23. The control unit 23 can includes a Central Processing Unit (CPU) and/or logic ports and/or Field-Programmable Gate Array (FPGA).

The first series I of operations includes:

a. injecting a positive current $I_{g,ref}$ from the emitter/source to the gate of said module 1, an initial voltage $V_{0,ref}$ of the module 1, gate-emitter/source, being superior to a flatband voltage $V_{fb}$,
b. measuring the voltage $V_{ig,ref}(t)$ across the current source,
c. stop the current injection $I_{g,ref}$ when the voltage of the module 1 becomes inferior to the flatband voltage $V_{fb}$.

In an embodiment wherein the first series I of operations is executed by the control circuitry 2, measures of the voltage $V_{ig,ref}(t)$ across the current source are made by the voltage measurement means. Before to stop the current injection $I_{g,ref}$, conditions can be monitored and detected by the control unit 23 through the ADC 25 of the control circuitry 2, or be imposed in a constant time, for example 2$\mu$s. When the conditions are fulfilled (the voltage of the module 1 becomes inferior to the flatband voltage $V_{fb}$), the control unit 23 send a control signal to the switch 26 of the control circuitry 2 to close it such that the current source 22 stops feeding the MOS element(s) 11.

The first series I of operations is executed at a known average temperature of the module 1, for example the maximum nominal average temperature of the module 1 during its operational life. This enables to obtain measures for the said average temperature. In the following examples, the average temperature is 135°C. The said temperature is adapted in function of each architecture and context of operations (applications and designs) of the modules 1. Optionally, the first series of operations can be repeated at various known average temperatures of the module 1 in order to obtain a plurality of sets of measurements, each one being related to a known average temperature.

Then (or before), the second series II of operations is executed. The second series II of operations is substantially similar to the first one I but is made during an operational state wherein the MOS is/are in an unknown state, or at least for which the temperature heterogeneity in the module 1 is looking for. Preferably, the average temperature of the module 1 is known.

The second series II of operations includes:

d. injecting a positive current $I_{g,op}$ (typically equal to the injected current $I_{g,ref}$ of the previous first series I) from the emitter/source to the gate of said module 1, an initial voltage $V_{0,op}$ of the module, gate-emitter/source, being superior to a flatband voltage $V_{fb}$,
e. measuring the voltage $V_{ig,op}(t)$ across the current source,
f. stop the current injection $I_{g,op}$ when the voltage of the module (1) becomes inferior to the flatband voltage $V_{fb}$.

In an embodiment wherein the second series II of operations is executed by the control circuitry 2, measures of the voltage $V_{ig,op}(t)$ across the current source are made by the voltage measurement means. Before to stop the current injection $I_{g,op}$, conditions can be monitored and detected by the control unit 23 through the ADC 25 of the control circuitry 2, or be imposed in a constant time, for example 2$\mu$s. When the conditions are fulfilled (the voltage of the module 1

becomes inferior to the flatband voltage $V_{fb}$), the control unit 23 send a control signal to the switch 26 of the control circuitry 2 to close it such that the current source 22 stops feeding the MOS element(s) 11.

During the second series II of operations, during the operation of the MOS element(s), and especially at a maximum operating point, the junction temperature can differ in a unique power semiconductor surface or on the several dies in parallel. Thus, the measured voltage $V_{ig,op}(t)$ across the current source differs from the measures obtained during the first series I of operations. In other words, the waveforms in function of the time t are not formed equally.

The operation of the module 1 can be driven by a Central Processing Unit (CPU), preferably the same as during the first series I of operations, like the control unit 23 of the control circuitry 2.

Then, the third series III of operations includes:

g. comparing the voltages $V_{ig,ref}(t)$ and $V_{ig,op}(t)$ measured respectively during one said first series I and one said second series II,
h. deducing, from the comparison, a temperature dispersion $T_{j,dev}$ across the module 1.

The third series III of operation is made by a processing unit, for example the calculation unit 24 of the control circuitry 2. In the examples described here, the calculation unit 24 is considered distinctly from the control unit 23 (see [Fig. 5]) to better understand their respective functions. In some embodiments, the calculation unit 24 can be a part of (integrated to) the control unit 23 and being structurally the same component, especially in the embodiments wherein an isolation is provided between the control unit 23 and the ADC 25,

The comparison of the voltages $V_{ig,ref}(t)$ and $V_{ig,op}(t)$ is preferably made for similar or close average temperatures of the module 1. The aim is to identify the variations on the acquired voltage given the temperature gradient among the power semiconductor elements 11 or within a unique power semiconductor element of the module 1. [Fig. 6] shows an example of such a comparison. In the example of [Fig. 6], the graphic represents the absolute difference of the voltages ($|V_{ig,ref}(t) - V_{ig,op}(t)|$) obtained during the first series I and the second series II in function of the time (t). In the said example, all the curves corresponding to an average temperature of the module 1 of 130°C and each curve corresponds to a temperature gradient (here from 0 to 20°C by step of 2°C) among the power semiconductor elements 11.

In an example, the deduction of the junction temperature dispersion $T_{j,dev}$ is based only on the maximum values of the absolute difference between the voltages $V_{ig,ref}(t)$ and $V_{ig,op}(t)$, multiplied by a predetermined factor K which is calculated from a simulation of the flatband behavior, e.g. K = 11 800 °C/V. This is represented in [Fig. 7].

The graphical representation of the comparison of [Fig. 7] is only an example to help the reader to understand but the method is not limited to any specific manner to execute such a comparison: the comparison can be made only with the numerical data measured and/or with a graphical analysis.

The temperature dispersion in a semiconductor region or the temperature dispersion of an array of semiconductors elements 11 connected in parallel can then be estimated using a unique indicator (voltage across the current source). Any individual access isn't necessary. Furthermore, the estimation is made for the most critic operating situation.

The comparison of the voltages $V_{ig,ref}(t)$ and $V_{ig,op}(t)$ is preferably made for similar or close average temperatures of the module 1. In order to ensure that, each of said at least one first series I and said at least one second series II further comprises:

i. acquiring an absolute average temperature $T_{av,ref}$ and $T_{av,op}$ of the module 1.

The second series II is repeatedly executed until that the difference between the absolute average temperatures $T_{av,ref}$ and $T_{av,op}$ acquired during said at least one first series I and during said second series II is equal or inferior to a predetermined value $\Delta T_{lim}$

For example, the average temperature can be determined using TSEP-based method known by itself, for example in function of the internal gate resistance. Such methods are explained in C. Chen, V. Pickert, B. Ji, C. Ji, A. Knoll and C. Ng, "*Comparison of TSEP Performances Operating at Homogeneous and Inhomogeneous Temperature Distribution in Multichip IGBT Power Modules*" IEEE Journal of Emerging and Selected Topics in Power Electronics. The measurement of the voltage $V_{ig,ref}(t)$ or $V_{ig,op}(t)$ at the initial instants, t1, after the current injection, eg. 500ns after the current injection, is representative of the average junction temperature. In the fact, the initial voltage just after the current injection is representative of the internal gate resistance $R_{g,in}$. It's known that this method represents the average junction temperature. The $V_{ig,ref}(t1)$ or $V_{ig,op}(t1)$ can be correlated to the absolute junction temperature during the first and second series I and II.

Advantageous, the temperature heterogeneity is calculated without the acknowledgment of the operating point of the power semiconductors. Furthermore, by using the $R_{g,in}$ TSEP-based method, a unique circuit is enough to measure the absolute average and the dispersion of the junction temperature in a unique power semiconductor or in paralleled power semiconductor elements 11.

In some embodiments, the first series I of operations to obtain $V_{ig,ref}(t)$ is made when the module 1 is in a reference state and not in an operational situation (typically in laboratory, product calibration phase or maintenance conditions). The first series I can be repeatedly made (N times) at various temperatures to obtain measures of $V_{ig,ref}$ (t) under various temperatures. In such conditions, the temperatures do not depend on the operational conditions and can be chosen/driven. For example, an external heating element can be disposed in the vicinity of the module 1, like a heating plate. In another example, the temperature of a heat sink where power dies are attached can be chosen/driven.

When the first series I of operations is made in a non-operational situation, then the temperature dispersion can be estimated for any average temperature during the power module usage with a good accuracy.

This is shown in [Fig. 8]:

- In a first loop 81, $V_{ig,ref}$ is measured for a first absolute average temperatures $T_{av,ref,y}$ in a situation where the temperature is known homogenous in the module 1 (the module 1 being off-line), which means the same at each junction of the module 1 ($T_{av,ref,y} = T_{j1,dev} = T_{j2,dev} = ... = T_{jN,dev}$). Then, the loop is reiterated for another absolute average temperatures $T_{av,ref,y+1}$ for each absolute average temperatures $T_{av,ref,y+N}$;
- Then, in a sub-step 82, the average temperature $T_{av,op}$ is determined, for example using TSEP-based method, like in function of the internal gate resistance;
- Then executing the measuring of the voltage $V_{ig,op}$(t) across the module 1 (operation e, corresponding to 83 in [Fig. 8];
- Then executing the comparison (operation g, corresponding to 84 in [Fig. 8]), preferably with the reference voltage $V_{ig,ref}$ obtained with absolute average temperatures $T_{av,ref,y}$ closest to the determined average temperature $T_{av,op}$;
- Then deducing (operation h, corresponding to 85 in [Fig. 8]), a temperature dispersion $T_{j,dev}$ across the module 1 as the minimum of the product of the factor K and the absolute difference between the two voltages $T_{j,dev} = K \cdot \max(|V_{ig,op} - V_{ig,ref}|)$.

In some other embodiments, the first series I of operations to obtain $V_{ig,ref}$ (t) is made when the module 1 is in a reference state during an operational situation, in an early stage of its usage, for example before reaching a predefined operating age of the module 1. Only as examples, the predefined operating age can be set as a percentage (strictly inferior to 100%, for example 5%, 10% or 20%) of a target/nominal lifetime limit, or it can be set as a number of hours, like 1 000, 2 000 or 10 000 hours depending on the module, operational conditions and/or an aimed safety level. The first series I can be repeatedly made (N times) at various temperatures to obtain measures of $V_{ig,ref}$ (t) under various temperatures. In such conditions, a set of measures for various known temperatures can be obtained.

Here, we define the "early stage" as a number of hours in operation. In such a case, a counter can be installed in the control unit 23 that enables to define the limit in time in which the first series is/are performed. In our example, the number is set as 100 hours. Within this time, no degradation will occur on the power semiconductor packaging (the module 1) and the temperatures of the power semiconductor element(s) are considered homogenous by the design. A person skilled in the art could adapt such a limit in view of the context.

When the first series I of operations is made in an early stage of operational situation, the temperature heterogeneity evolution during the lifetime in case of the deterioration of the power semiconductor elements can be retrieved. Furthermore, any commissioning phase is necessary before the usage of power semiconductor. Consequently, the $V_{ig,ref}$ (t) used as reference is generated during the field application reducing the manufacturing complexity.

In some embodiments, said third series III further comprises, before comparison:

g'. adjusting, in time and in offset, the measured voltage $V_{ig,op}$ (t) during the at least one second series II with respect to the waveform of the measured voltage $V_{ig,ref}$ (t) during the at least one first series I.

Such operation can be explained by the principle that the flatband voltage changes in time and voltage amplitude dependently on the drain-source voltage and/or average temperature. However it does not impact on the shape of the waveform. An example of an algorithm to execute the offset and time shift is represented on [Fig. 9]. The algorithm searches the instant, ts, where the waveforms have the same amplitude for the first time. In this purpose, the algorithm first compares the initial voltages of $V_{ig,op}$ ($t_0$), $V_{ig,ref}$ ($t_0$) at step 91. Thus, it moves to steps 92 or 93, where it searches for the voltage where Vx($t_0$) is equal to Vy($t_3$) (Vx being the $V_{ig,op}$ and Vy being the $V_{ig,op}$ at step 92 and the opposite in step 93). Therefore, the time delay $t_3$ can be compensated at the smaller amplitude waveform based on the biggest Vx($t_0$), which guarantee that $V_{ig,op}$ ($t_0$) = $V_{ig,ref}$ ($t_0$). Then the algorithm moves to step 94, where the amplitude offset is removed. The offset is defined as being the voltage difference at a time $t_2$ that is placed in the middle of the plateau of the $V_{ig,ref}$ (t) waveform, for example at 1μs. If this offset is smaller enough, example 4mV, then the algorithm has converged the waveforms, otherwise, the algorithm returns to step 91. The algorithm can be stopped after a number of interactions. According to experiments, five interactions are enough. [Fig. 10] and [Fig. 11] are graphical representations of the measured voltage $V_{ig,op}$ (t) respectively before and after the adjusting operation, the after being referenced as a function "Adj($V_{ig,op}$ (t))". In these figures the difference between $V_{ig,op}$ (t) and $V_{ig,op}$ (t) are obtained at different bus voltages and average junction temperatures, with no inhomogeneity present. As demonstrated, this adjustment enables to remove the offset and delays introduced by external factors as the average temperatures or drain-source voltages. Only the temperature inhomogeneity changes the shape of the waveform, thus the difference between "Adj($V_{ig,op}$ (t))"

and $V_{ig,op}$ (t) will result in the same difference as shown in [Fig. 6], where the results are exploited in [Fig. 7] by taking the maximum. A resulting variation after the adjustment in function of the standard deviation of the junction temperatures is shown on [Fig. 12]. In such an example, the temperature gradient can be retrieved with a coefficient K = 1 650 °C/V.

In some embodiments, a single measurement of $V_{ig,ref}$ (t) is made. An arbitrary average junction temperature is determined. This reduces the time of the calibration after the manufacturing of module.

In some embodiments, each first series I is executed when the power transferred by the module 1 is inferior to a predefined limit strictly inferior to a nominal maximum load of the module 1. Only as examples, the predefined limit can be set as a percentage (strictly inferior to 100%, for example 5%, 10% or 20%) of a target/nominal maximum load. In various embodiments, a limit condition can be set as a maximum allowed power dissipation, like 5%, 10% or 20% of a nominal maximum power dissipation, depending on the module, operational conditions and/or an aimed safety level. A combination of such limits can be implemented. For example, predetermined conditions can be set into a control unit 23 to trigger the voltage $V_{ig,ref}$(t) acquisition. The following conditions give good results:

- the power semiconductor element(s) is/are not switching, and a non-zero drain-source voltage $V_{ds}$, or a non-zero collector-emitter voltage $V_{ce}$ is present across the power semiconductor element(s); or
- a small collector-emitter current $I_{ce}$ or small drain-source current $I_{ds}$ is flowing through the power semiconductor element(s) when a non-zero drain-source or collector-emitter voltage, is present across the power semiconductor element(s) and the last one is switching.

The $V_{ce}$ or $V_{ds}$ can be measured and stored in a table linked to the voltage $V_{ig,ref}$ (t). In such a case, the comparison (operation g) can be made when the $V_{ig,ref}$ obtained is the same, or near, the $V_{ce}$ or $V_{ds}$ values.

Advantageous, the sensitivity of the flatband voltage with the $V_{ce}$ and $V_{ds}$ voltages can be compensated and the deterioration of the flatband, caused by the accumulation of charges on the gate oxide, is also compensated.

**Theory**

The flatband voltage $V_{fb}$ represents the voltage applied to the gate when no charge is present in the oxide or at the oxide-semiconductor interface that yields a flat band energy in the semiconductor. The voltage is the difference between the gate metal workfunction and the semiconductor workfunction. The workfunction is the voltage required to extract an electron from the Fermi energy to the vacuum level. This voltage separates the accumulation mode to the depletion mode of a MOS (metal oxide semiconductor) structure. During the accumulation mode, the MOS capacitance C is only related to the oxide capacitance. During the depletion mode, the MOS equivalent capacitance is a series connection of the oxide capacitance and the variable capacitance of the depletion layer $C_{eq}$.

In operational context, the power semiconductors are classically operated by a main controlled that alternates the on and off state modes by applying a positive voltage $V_{ge}$ (eg. 15V) and a negative voltage $V_{ge}$ (e.g. -15V) respectively.

Here, the temperature dispersion is measured by considering the change on the gate-emitter voltage behavior when the MOS capacitor is pre-charge to a voltage $V_{ge}$ higher than the MOS flatband voltage (for example around -2V) and a low amplitude current source (for example 1mA-100mA) discharges the MOS capacitor until the voltage $V_{ge}$ is inferior to the flatband voltage $V_{fb}$ that can vary between power semiconductor references and its normally comprised in a known range, for example from -10V to -3V. The discharge characteristics can be seen on [Fig. 13] on which the flatband signature on the $V_{ge}$ voltage of an IGBT can be seen. The discharge of the MOS capacitor shows a plateau during the flatband voltage which can be readily identified and be dependent on the junction temperature. This specific relation between the flatband voltage $V_{fb}$ and the junction temperature $T_j$ enables to deduce the temperature dispersion $T_{j,dev}$ in function of the voltages dispersions.

In order to determine the flatband voltages $V_{fb}$ of dies (or any semiconductor element), the input impedance of the power semiconductor element can be model by the equivalent capacitor $C_{eq}$. Thus, using a current source $I_g$ is an advantage in this method as the amount of charge Qt injected on the gate of the power semiconductor element (see [Math. 1]) is controlled and proportional to the equivalent capacitor (see [Math. 2]).

[Math. 1]

$$Q_t = I_g \cdot (t - t_0) = \sum_{n=1..N} (Q_n(t) - Q_n(t_0))$$

[Math. 2]

$$V_{ig} = \frac{Q_t}{C_{eq}} \; with \; C_{eq} = \sum_{n=1..N} C(V_{fb}^n)$$

$Q_n$ being the charge stored in the $n^{th}$ semiconductor, $t_0$ being the initial time and $t$ being the current time. As the equivalent capacitor $C_{eq}$ is dependent on the each flatband voltage $V^n_{fb}$, the measure of the voltage $V_{ig}$ enables to determine the equivalent capacitor factor at each instant of the time $t$. Using a voltage $V_{ig}$ acquired in a homogeneous temperature and compared to a voltage $V_{ig}$ acquired in an unknown situation enables to determine the variation on the flatband voltage $V_{fb}$. Thus, methods to explore the variation on $V_{ig}$ is proposed here to extract the flatband inhomogeneities related to the temperature inhomogeneities.

**Industrial Applicability**

The technical solutions presented here can be used to deduce junction temperature dispersion (temperature inhomogeneities) of at least one power semiconductor MOS type or paralleled connected power semiconductor MOS types by using flatband voltage measurement methods on the paralleled gate/source-emitter access of the parallel power elements in order to identify the signature of the individual flatband voltages and thus deduce the individual junction temperatures. As the flatband voltage signature is also affected by the operating point of the power semiconductor element(s) (e.g. drain-source / collector-emitter voltage), the individual temperatures are deduced in relative values.

Advantageous, the temperature dispersion in the semiconductor region or the temperature dispersion of an array of semiconductors connected in parallel can be estimated using a unique indicator (voltage across the current source), thus any individual access becomes unnecessary.

**Reference Signs List**

- 1: module
- 2: control circuitry
- 11: element
- 21: voltage source
- 22: current source
- 23: control unit
- 24: calculation unit
- 25: Analog-to-Digital Converter (ADC)
- 26: switch
- 81: loop
- 82: sub-step
- 83: operation
- 84: operation
- 85: operation.

**Claims**

1. A measurement method for estimating temperatures of a power semi-conductor module (1) comprising a single Metal-Oxide-Semiconductor, a single Metal-insulator-Semiconductor or a set of Metal-Oxide-Semiconductors or Metal-insulator-Semiconductor paralleled connected, said method comprising:

   - at least one first series (I) of operations, during which the module (1) is in a reference state, including

     a. injecting a positive current $I_{g,ref}$ from the emitter/source to the gate of said module (1), an initial voltage $V_{0,ref}$ of the module (1), i.e. a gate-emitter/source voltage ($V_{ge}$), being superior to a flatband voltage $V_{fb}$,
     b. measuring the voltage $V_{ig,ref}(t)$ across the current source,
     c. stop the current injection $I_{g,ref}$ when the voltage of the module (1) $V_{ge}$ becomes inferior to the flatband voltage $V_{fb}$,

- at least one second series (II) of operations, during which the module (1) is in a operational state, including

   d. injecting a positive current $I_{g,op}$ from the emitter/source to the gate of said module (1), an initial voltage $V_{0,op}$ of the module, i.e. a gate-emitter/source voltage ($V_{ge}$), being superior to a flatband voltage $V_{fb}$,
   e. measuring the voltage $V_{ig,op}(t)$ across the current source,
   f. stop the current injection $I_{g,op}$ when the voltage of the module (1) $V_{ge}$ becomes inferior to the flatband voltage $V_{fb}$,
   then,

- at least one third series (III) of operations including

   g. comparing the voltages $V_{ig,ref}(t)$ and $V_{ig,op}(t)$ measured respectively during one said first series (I) and one said second series (II),
   h. deducing, from the comparison, a temperature dispersion $T_{j,dev}$ across the module (1).

2. The method according to claim 1, wherein each of said at least one first series (I) and said at least one second series (II) further comprises:

   i. acquiring an absolute average temperature $T_{av,ref}$ and $T_{av,op}$ of the module (1),

   and wherein said second series (II) is repeatedly executed until the difference between the absolute average temperatures $T_{av,ref}$ and $T_{av,op}$ acquired during said at least one first series (I) and during said second series (II) is equal or inferior to a predetermined value $\Delta T_{lim}$.

3. The method according to claim 2, wherein a plurality of said first series (I) is executed at different absolute average temperatures $T_{av,ref,n}$,
   and wherein said first series (I) are executed during states different from an operational state of the module (1).

4. The method according to one of claims 1 to 3, wherein a plurality of said first series (I) is executed at different absolute average temperatures $T_{av,ref,n}$,
   wherein each said first series (I) is executed during a reference and operational state of the module (1), and before reaching a predefined operating age limit in operational operation of said module (1).

5. The method according to one of claims 1 to 4, wherein said third series (III) further comprises, before comparison:
   g'. adjusting, in time and in offset, the measured voltage $V_{ig,op}(t)$ during said at least one second series (II) with respect to the waveform of the measured voltage $V_{ig,ref}(t)$ during said at least one first series (I).

6. The method according to claim 5, wherein each said at least one first series (I) is executed when the power transferred by the module (1) is inferior to a predefined limit strictly inferior to the nominal maximum load of the module (1).

7. A system for estimating temperatures of a power semi-conductor module (1) comprising a single Metal-Oxide-Semiconductor, a single Metal-insulator-Semiconductor or a set of Metal-Oxide-Semiconductors or Metal-insulator-Semiconductors paralleled connected, said system comprising said module (1) and a control circuitry (2) including :

   - a voltage source (21) for pre-setting the voltages of the MOS/MIS elements of the module (1) ;
   - a current source (22) for injecting a current from the emitter/source to the gate of the module (1) ;
   - a control unit (23) to control the current source (22) ;
   - voltage measurement means ;
   - a calculation unit (24) for calculating a temperature dispersion a temperature dispersion $T_{j,dev}$ across the module (1) ;

   said system being arranged to implement the method according to one of claims 1 to 6.

8. Computer software comprising instructions to cause the system of claim 7 to implement the method according to one of claims 1 to 6 when the software is executed by a processor.

9. Computer-readable non-transient recording medium on which a computer software according to claim 8 is registered, wherein the computer software comprises instructions to cause the system of claim 7 to implement the method according to one of claims 1 to 6 when the software is executed by a processor.

**Patentansprüche**

1. Messverfahren zum Schätzen von Temperaturen eines Leistungshalbleitermoduls, das einen einzelnen Metalloxidhalbleiter, einen einzelnen Metallisolatorhalbleiter oder einen Satz von Metalloxidhalbleitern oder Metallisolatorhalbleitern, die parallel verbunden sind, wobei das Verfahren aufweist:

   - zumindest eine erste Serie (I) von Operationen, während der das Modul (1) in einem Referenzzustand ist, enthaltend

     a. Injizieren eines positiven Stroms $I_{g,ref}$ vom Emitter/Source zum Gate des Moduls (1), wobei eine Anfangsspannung $V_{0,ref}$ des Moduls (1), d.h. eine Gate-Emitter/Source-Spannung ($V_{ge}$) oberhalb einer Flachbandspannung $V_{fb}$ liegt,
     b. Messen der Spannung $V_{ig,ref}(t)$ über der Stromquelle,
     c. Stoppen der Strominjektion $I_{G,ref}$, wenn die Spannung des Moduls (1) $V_{ge}$ niedriger als die Flachbandspannung $V_{fb}$ wird,

   - zumindest eine Serie (II) von Operationen, während der das Modul (1) in einem Betriebszustand ist, enthaltend

     d. Injizieren eines positiven Stroms Ig,op vom Emitter/Source zum Gate des Moduls (1), wobei eine Anfangsspannung V0,op des Moduls, d.h. eine Gate-Emitter/Source-Spannung ($V_{ge}$) oberhalb einer Flachbandspannung $V_{fb}$ liegt,
     e. Messen der Spannung $V_{ig,op}(t)$ über der Stromquelle,
     f. Stoppen der Strominjektion $I_{g,op}$, wenn die Spannung des Moduls (1) $V_{ge}$ niedriger als die Flachbandspannung $V_{fb}$ wird,
     dann

   - zumindest eine dritte Serie (III) von Operationen, enthaltend g. Vergleichen der Spannungen $V_{ig,ref}(t)$ und $V_{ig,op}(t)$, die jeweils während einer der ersten Serie (I) und einer der zweiten Serie (II) gemessen werden,
     h. Herleiten, aus dem Vergleich, einer Temperaturverteilung $T_{j,dev}$ über dem Modul (1).

2. Das Verfahren nach Anspruch 1, worin jede der zumindest einen ersten Serie (I) und der zumindest einen zweiten Serie (II) ferner aufweist:

     i. Erfassen einer absoluten Durchschnittstemperatur $T_{av,ref}$ und $T_{av,op}$ des Moduls (1),

   und wobei die zweite Serie (II) wiederholt ausgeführt wird, bis die Differenz zwischen den absoluten Durchschnittstemperaturen $T_{av,ref}$ und $T_{av,op}$, die während der zumindest einen ersten Serie (I) und während der zweiten Serie (II) erfasst werden, gleich oder niedriger als ein vorbestimmter Wert $\Delta T_{lim}$ ist.

3. Das Verfahren nach Anspruch 2, wobei eine Mehrzahl der ersten Serie (I) bei unterschiedlichen absoluten Durchschnittstemperaturen $T_{av,ref,n}$ ausgeführt wird, und wobei die ersten Serien (I) während Zuständen ausgeführt werden, die sich von einem Betriebszustand des Moduls (1) unterscheiden.

4. Das Verfahren nach einem der Ansprüche 1 bis 3, wobei eine Mehrzahl der ersten Serie (I) bei unterschiedlichen absoluten Durchschnittstemperaturen $T_{av,ref,n}$ ausgeführt wird, wobei jede der ersten Serie (I) während eines Referenz- und eines Betriebszustands des Moduls (1) und bevor eine vordefinierte Betriebsalterungsgrenze eines Operationsbetriebs des Moduls (1) erreicht wird, ausgeführt wird.

5. Das Verfahren nach einem der Ansprüche 1 bis 4, wobei die dritte Serie (III) ferner, vor dem Vergleich, aufweist: g' Justieren, in Zeit und Versatz, der gemessenen Spannung $V_{ig,op}(t)$, während der die zumindest eine zweite Serie (II) in Bezug auf die Wellenform der gemessenen Spannung $V_{ig,ref}(t)$ während der zumindest einen Serie (I).

6. Das Verfahren nach Anspruch 5, wobei jede der zumindest einen ersten Serie (I) ausgeführt wird, wenn die von dem Modul (1) übertragene Leistung niedriger als eine vordefinierte Grenze ist, die strikt niedriger ist als die nominale Maximallast des Moduls (1).

7. System zum Schätzen von Temperaturen eines Leistungshalbleitermoduls (1), das einen einzelnen Metalloxidhalbleiter, einen einzelnen Metallisolatorhalbleiter oder einen Satz von Metalloxidhalbleitern oder Metallisolatorhalbleitern, die parallel verbunden sind, aufweist, wobei das System das Modul (1) und eine Steuerschaltung (2) aufweist, enthaltend:

- eine Spannungsquelle (21) zum Voreinstellen der Spannung der MOS/MIS-Elemente des Moduls (1);
- eine Stromquelle (22) zum Injizieren eines Stroms vom Emitter/Source zum Gate des Moduls (1);
- eine Steuereinheit (23) zur Steuerung der Stromquelle (22);
- ein Spannungsmessmittel;
- eine Recheneinheit (24) zum Berechnen einer Temperaturverteilung einer Temperaturverteilung $T_{j,dev}$ über dem Modul (1);

wobei das System angeordnet ist, um das Verfahren nach einem der Ansprüche 1 bis 6 zu implementieren.

8. Computersoftware, die Anweisungen aufweist, um zu veranlassen, dass das System von Anspruch 7 das Verfahren nach einem der Ansprüche 1 bis 6 implementiert, wenn die Software von einem Prozessor ausgeführt wird.

9. Computerlesbares, nichtflüchtiges Aufzeichnungsmedium, auf dem eine Computersoftware nach Anspruch 8 registriert ist, wobei die Computersoftware Anweisungen aufweist, um zu veranlassen, dass das System von Anspruch 7 das Verfahren nach einem der Ansprüche 1 bis 6 implementiert, wenn die Software von einem Prozessor ausgeführt wird.

**Revendications**

1. Procédé de mesure pour estimer les températures d'un module semiconducteur de puissance (1) comprenant un seul métal-oxyde-semiconducteur, un seul métal-isolant-semiconducteur ou un ensemble de métal-oxyde-semiconducteurs ou de métal-isolant-semiconducteurs connectés en parallèle, ledit procédé comprenant :

- au moins une première série (I) d'opérations, pendant laquelle le module (1) est dans un état de référence, comprenant

a. l'injection d'un courant positif $I_{g,ref}$ à partir de l'émetteur/la source dans la grille dudit module (1), une tension initiale $V_{0,ref}$ du module (1), c'est-à-dire une tension de grille-émetteur/source ($V_{ge}$), étant supérieure à une tension à large bande $V_{fb}$,
b. la mesure de la tension $V_{ig,ref}(t)$ traversant la source de courant,
c. l'arrêt de l'injection de courant $I_{g,ref}$ lorsque la tension du module (1) $V_{ge}$ devient inférieure à la tension à large bande $V_{fb}$,

- au moins une deuxième série (II) d'opérations, pendant laquelle le module (1) est dans un état de fonctionnement, comprenant

d. l'injection d'un courant positif $I_{g,op}$ à partir de l'émetteur/la source dans la grille dudit module (1), une tension initiale $V_{0,op}$ du module, c'est-à-dire une tension de grille-émetteur/source ($V_{ge}$), étant supérieure à une tension à large bande $V_{fb}$,
e. la mesure de la tension $V_{ig,op}(t)$ traversant la source de courant,
f. l'arrêt de l'injection de courant $I_{g,op}$ lorsque la tension du module (1) $V_{ge}$ devient inférieure à la tension à large bande $V_{fb}$,
puis,

- au moins une troisième série (III) d'opérations comprenant

g. la comparaison des tensions $V_{ig,ref}(t)$ et $V_{ig,op}(t)$ mesurées respectivement pendant l'une desdites premières séries (I) et l'une desdites deuxièmes séries (II),
h. la déduction, à partir de la comparaison, d'une dispersion de température $T_{j,dev}$ à travers le module (1).

**2.** Procédé selon la revendication 1, dans lequel chacune de ladite au moins une première série (I) et de ladite au moins une deuxième série (II) comprend en outre :

i. l'acquisition d'une température moyenne absolue $T_{av,ref}$ et $T_{av,op}$ du module (1),

et dans lequel ladite deuxième série (II) est exécutée à plusieurs reprises jusqu'à ce que la différence entre les températures moyennes absolues $T_{av,ref}$ et $T_{av,op}$ acquises pendant ladite au moins une première série (I) et pendant de ladite deuxième série (II) soit inférieure ou égale à une valeur $\Delta T_{lim}$ prédéterminée.

**3.** Procédé selon la revendication 2, dans lequel une pluralité de ladite première série (I) sont exécutées à différentes températures moyennes absolues $T_{av,ref,n}$,
et dans lequel lesdites premières séries (I) sont exécutées pendant des états différents d'un état de fonctionnement du module (1).

**4.** Procédé selon l'une des revendications 1 à 3, dans lequel une pluralité de ladite première série (I) est exécutée à différentes températures moyennes absolues $T_{av,ref,n}$, dans lequel chacune desdites premières séries (I) est exécutée pendant un état de référence et de fonctionnement du module (1), et avant d'atteindre une limite d'âge de fonctionnement prédéfinie de fonctionnement opérationnel dudit module (1).

**5.** Procédé selon l'une des revendications 1 à 4, dans lequel ladite troisième série (III) comprend en outre, avant la comparaison :
g'. l'ajustement, en temps et en décalage, de la tension $V_{ig,op}(t)$ mesurée pendant ladite au moins une deuxième série (II) par rapport à la forme d'onde de la tension $V_{ig,ref}(t)$ mesurée pendant ladite au moins une première série (I).

**6.** Procédé selon la revendication 5, dans lequel chacune de ladite au moins une première série (I) est exécutée lorsque la puissance transférée par le module (1) est inférieure à une limite prédéfinie strictement inférieure à la charge maximale nominale du module (1).

**7.** Système pour estimer les températures d'un module semiconducteur de puissance (1) comprenant un seul métal-oxyde-semiconducteur, un seul métal-isolant-semiconducteur ou un ensemble de métal-oxyde-semiconducteurs ou de métal-isolant-semiconducteurs connectés en parallèle, ledit système comprenant ledit module (1) et un circuit de commande (2) comprenant :

- une source de tension (21) pour prérégler les tensions des éléments MOS/MIS du module (1) ;
- une source de courant (22) pour injecter un courant à partir de l'émetteur/la source dans la grille dudit module (1) ;
- une unité de commande (23) pour commander la source de courant (22) ;
- un moyen de mesure de tension ;
- une unité de calcul (24) pour calculer une dispersion de température $T_{j,dev}$ à travers le module (1) ;

ledit système étant agencé pour mettre en oeuvre le procédé selon l'une des revendications 1 à 6.

**8.** Logiciel informatique comprenant des instructions pour amener le système de la revendication 7 à mettre en oeuvre le procédé selon l'une des revendications 1 à 6 lorsque le logiciel est exécuté par un processeur.

**9.** Support d'enregistrement non transitoire lisible par ordinateur sur lequel un logiciel informatique selon la revendication 8 est enregistré, dans lequel le logiciel informatique comprend des instructions pour amener le système de la revendication 7 à mettre en oeuvre le procédé selon l'une des revendications 1 à 6 lorsque le logiciel est exécuté par un processeur.

FIG. 1

FIG. 2

FIG. 3

**FIG. 4**

**FIG. 5**

EP 4 249 874 B1

FIG. 6

FIG. 7

FIG. 8

EP 4 249 874 B1

FIG. 9

**FIG. 10**

**FIG. 11**

**FIG. 12**

**FIG. 13**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Selective Gate Driving in Intelligent Power Modules. **BRANDELERO JULIO et al.** IEEE TRANSACTIONS ON POWER ELECTRONICS. INSTITUTE OF ELECTRICAL AND ELECTRONICS ENGINEERS, 12 June 2020, vol. 36, 898-910
- **C. CHEN ; V. PICKERT ; B. JI ; C. JI ; A. KNOLL ; C. NG.** Comparison of TSEP Performances Operating at Homogeneous and Inhomogeneous Temperature Distribution in Multichip IGBTPower Modules. *IEEE Journal of Emerging and Selected Topics in Power Electronics*

- **M. HOEER ; F. FILSECKER ; M. WAGNER ; S. BERNET.** Application issues of an online temperature estimation method in a high-power 4.5 kV IGBT module based on the gate-emitter threshold voltage. *2016, 18th European Conference on Power Electronics and Applica*